(19) Europäisches Patentamt
European Patent Office
Office européen des brevets

(11) **EP 3 498 661 B1**

(12) **FASCICULE DE BREVET EUROPEEN**

(45) Date de publication et mention
de la délivrance du brevet:
**03.03.2021   Bulletin 2021/09**

(51) Int Cl.:
***B81B 3/00*** *(2006.01)*

(21) Numéro de dépôt: **18211683.0**

(22) Date de dépôt: **11.12.2018**

(54) **DISPOSITIF MICROELECTROMECANIQUE ET/OU NANOELECTROMECANIQUE OFFRANT UNE ROBUSTESSE AUGMENTEE**

MIKRO- UND/ODER NANOELEKTROMECHANISCHE VORRICHTUNG, DIE EINE ERHÖHTE ROBUSTHEIT BIETET

MICROELECTROMECHANICAL AND/OR NANOELECTROMECHANICAL DEVICE PROVIDING INCREASED STURDINESS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **12.12.2017   FR 1761989**

(43) Date de publication de la demande:
**19.06.2019   Bulletin 2019/25**

(73) Titulaire: **Commissariat à l'énergie atomique et aux énergies alternatives**
**75015 Paris (FR)**

(72) Inventeur: **LHERMET, Hélène**
**38240 MEYLAN (FR)**

(74) Mandataire: **Brevalex**
**95, rue d'Amsterdam**
**75378 Paris Cedex 8 (FR)**

(56) Documents cités:
**WO-A1-2007/136096     US-A1- 2016 349 056**

## Description

**DOMAINE TECHNIQUE ET ÉTAT DE LA TECHNIQUE ANTÉRIEURE**

La présente invention se rapporte à un dispositif microélectromécanique et/ou nanoélectromécanique offrant une souplesse et une robustesse augmentées.

Les dispositifs microélectromécaniques ou MEMS (Microelectromechanical Systems en terminologue anglo-saxonne) et/ou nanoélectromécaniques (Nanoelectromechanical Systems en terminologue anglo-saxonne) sont utilisés pour réaliser des capteurs miniaturisés tels que des accéléromètres, gyromètres, capteurs de pression, microphones, et des actionneurs miniaturisés par exemple pour réaliser des micromiroirs orientables.

Les dispositifs MEMS et/ou NEMS comportent au moins un élément mobile suspendu. Dans le cas d'un accéléromètre, l'élément mobile ou masse est déplacé sous l'effet d'une force d'accélération. Son déplacement est mesuré, ce qui permet de déterminer la valeur de l'accélération.

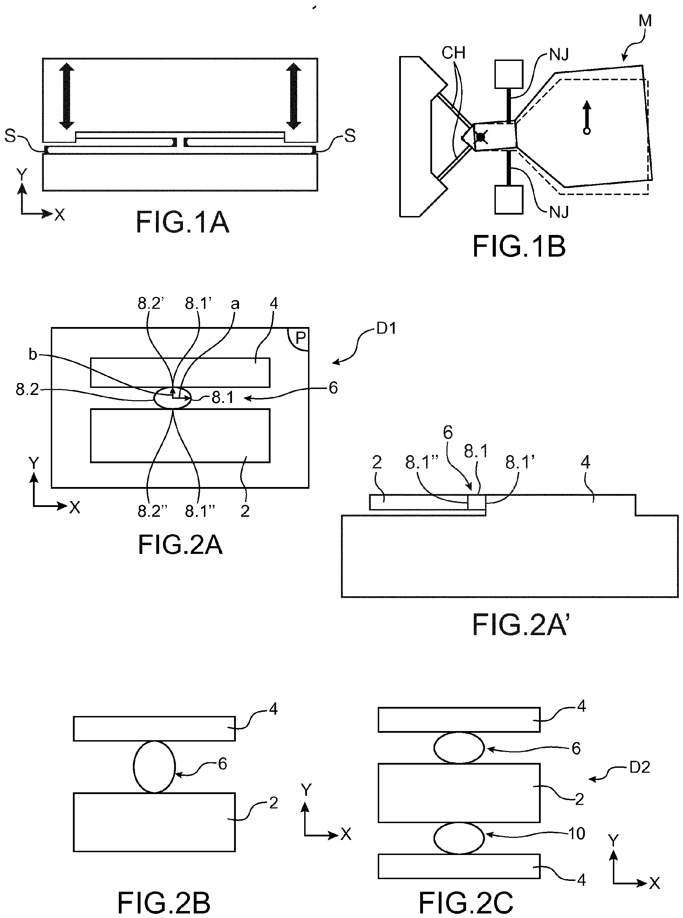

Les dispositifs MEMS et/ou NEMS peuvent mettre en œuvre des moyens de suspension S comportant des poutres reliées entre elles par leurs extrémités en forme de zigzag, comme cela est représenté sur la figure 1A. Lors du déplacement de l'élément mobile, les moyens de suspension se déforment : les poutres s'écartent ou se rapprochent les unes des autres. Une concentration de contraintes apparaît au niveau de la connexion des poutres. De tels dispositifs peuvent être utilisés pour réaliser des capteurs, pour cela des moyens de détection du déplacement de l'élément mobile sont mis en œuvre, par exemple des jauges piézorésistives.

La figure 1B représente un capteur à détection piézorésistive MEMS et NEMS décrit dans le document EP2491406. Le capteur comporte une masse mobile M formant la partie MEMS articulée en rotation par une charnière CH par rapport à une partie fixe autour d'un axe orthogonal au plan du substrat. Sous l'effet d'une accélération de direction donnée, la masse M est déplacée en rotation dans le plan. Des nanojauges piézorésistives NJ, formant la partie NEMS, sont suspendues entre la masse et la partie fixe par rapport au substrat de sorte à être déformées lors du déplacement de la masse dans le plan. La disposition des nanojauges NJ et la position du centre de gravité de la masse par rapport à l'axe de rotation sont telles qu'un effet bras de levier apparaît, qui a un effet amplificateur sur la déformation des jauges, augmentant la sensibilité du capteur.

Ce dispositif donne satisfaction. Cependant la mise en œuvre d'une charnière ou articulation pivot entre la masse et la partie fixe peut réduire la souplesse et la robustesse du capteur, en effet le dispositif peut être fragilisé au niveau de la charnière. En outre il peut y avoir une concentration de contrainte au niveau de la charnière.

Le document WO 2007/136096 décrit un actionneur électrostatique comportant deux parties mobiles l'une par rapport à l'autre et reliées par des lames élastiques de forme incurvée.

Le document US 2016/0349056 décrit un dispositif MEMS pour des gyroscopes, magnétomètres ou accéléromètres où un élément de suspension est en forme de demi-ellipse.

**EXPOSÉ DE L'INVENTION**

C'est par conséquent un but de la présente invention d'offrir un dispositif MEMS et/ou NEMS offrant une souplesse et une robustesse augmentées.

Le but énoncé ci-dessus est atteint par un dispositif comportant une partie fixe par rapport au substrat et une partie suspendue par rapport à ladite partie fixe par des moyens de suspension, ladite partie suspendue étant destinée à se déplacer dans le plan du dispositif. Les moyens de suspension comportent au moins un élément relié par une première extrémité directement à la partie suspendue et par une deuxième extrémité à la partie fixe, ledit élément comportant une forme courbe s'étendant de sa première extrémité à sa deuxième extrémité.

L'élément de suspension est destiné à être sollicité uniquement de manière élastique. Il ne comporte pas plusieurs portions connectées de sorte à former des zones anguleuses. Ainsi il ne comporte pas de zone fragile et présente une grande robustesse.

Le moyen de suspension de forme courbe, assure un guidage, en introduisant une souplesse dans la direction de déplacement souhaitée et une raideur dans les deux autres directions.

Il résulte de la mise en œuvre d'un moyen de suspension de forme courbe, une souplesse augmentée de la suspension dans la direction souhaitée. En effet, la déformation élastique est répartie sur l'ensemble de la forme courbe. Ainsi, chaque point de la forme courbe reste dans la partie élastique très linéaire de la courbe de déformation du matériau en fonction de la contrainte appliquée, introduisant moins de pertes mécaniques et donc un amortissement plus faible du mouvement par la suspension. Au contraire, dans les suspensions de l'état de la technique, localement, i.e. dans les points pivots, la zone de non-linéarité de la courbe de déformation peut être atteinte.

Il en résulte également, et pour les raisons énoncés ci-dessus, une plus grande robustesse de la suspension.

Dans un mode avantageux, les moyens de suspension comportent deux éléments disposés de sorte à former sensiblement une ellipse. Les contraintes sont alors réparties dans la suspension elliptique. Le dispositif présente alors une robustesse augmentée.

Dans un mode particulièrement avantageux, une ou plusieurs jauges de contrainte, par exemple des jauges piézorésistives ou piézoélectriques, sont mises en œuvre, par exemple dans des moyens de détection. Les jauges sont avantageusement associées directement aux moyens de suspension elliptiques, de sorte qu'il y ait un effet amplificateur ou réducteur entre l'amplitude de déplacement de la masse mobile et l'amplitude de déplacement au niveau des moyens de détection. Par exemple les moyens de détection comportent au moins une jauge de contrainte, la déformation appliquée à la jauge pouvant être amplifiée.

Par rapport aux capteurs dans lesquels la masse est mobile en rotation et dont la détection utilise un bras de levier, le dispositif selon un exemple de l'invention bénéficie d'un effet d'amplification et présente donc une sensibilité augmentée, sans mettre en œuvre d'articulation pivot.

En outre le capteur selon l'invention est de conception plus simple que ceux de l'état de la technique à bras de levier, car les couplages entre les variables de dimensionnement sont moins nombreux que dans le cas des capteurs mettant en œuvre un bras de levier.

L'invention présente en outre l'avantage de pouvoir être réalisée avec les procédés microélectronique habituellement mis en œuvre pour les dispositifs de l'état de la technique.

La présente invention a alors pour objet un dispositif microélectromécanique et/ou nanoélectromécanique comportant une partie fixe, au moins une partie suspendue destinée à être mobile dans le plan dudit dispositif par rapport à la partie fixe le long au moins d'une première direction, un premier moyen de suspension de ladite partie suspendue, ledit premier moyen de suspension comportant au moins un élément de suspension, ledit élément de suspension comportant une première extrémité fixée directement à la partie suspendue et une deuxième extrémité reliée la partie fixe, ledit élément de suspension présentant une forme courbe dans le plan s'étendant entre la première extrémité et la deuxième extrémité et telle que lors du déplacement dans le plan de ladite partie suspendue, ledit élément de suspension soit uniquement déformé élastiquement. Ledit au moins un élément de suspension est en forme au moins de demi-ellipse. Le dispositif comporte également au moins une jauge de contrainte dont une des extrémités est fixée sur l'élément de suspension et l'autre est ancrée sur la partie fixe par rapport au substrat.

Avantageusement, le dispositif comporte deux éléments de suspension, chacun en forme de demi-ellipse, et disposés l'un par rapport à l'autre de sorte à former une ellipse.

Dans un exemple de réalisation, le dispositif comporte un deuxième moyen de suspension comportant au moins un élément de suspension de ladite partie suspendue à ladite partie fixe, ledit élément de suspension comportant une première extrémité fixée directement à la partie suspendue, et une deuxième extrémité reliée à la partie fixe, ledit élément de suspension présentant une forme courbe contenue dans le plan, et s'étendant entre la première extrémité et la deuxième extrémité et telle que, lors du déplacement dans le plan de ladite partie suspendue, ledit élément de suspension soit uniquement déformé élastiquement, ledit deuxième moyen de suspension étant disposé par rapport à la partie mobile et aux premiers moyens de suspension, de sorte que, lors d'un déplacement de la partie mobile, lorsque le premier moyen de suspension est déformé en compression, le deuxième moyen de suspension est déformé en traction et inversement.

Le dispositif peut comporter avantageusement au moins deux jauges de contrainte chacune étant fixée à un élément de suspension.

Selon un exemple de réalisation, le premier moyen de suspension et/ou le deuxième moyen de suspension est (sont) orienté(s) de sorte que leur grand axe (a) est parallèle à la première direction, et au moins une jauge de contrainte est alignée avec le petit axe, de sorte que l'extrémité mobile de la jauge de contrainte subisse un déplacement amplifié par rapport à celui de la partie mobile.

Dans un exemple particulier le premier moyen de suspension et/ou le deuxième moyen de suspension et/ou le troisième moyen de suspension comporte(nt) un premier élément de forme elliptique et un deuxième élément de forme elliptique disposé dans le premier élément de forme elliptique et lié mécaniquement à celui-ci, le premier élément de forme elliptique étant fixé sur la partie mobile et le deuxième élément de forme elliptique étant fixé uniquement sur le premier élément de forme elliptique. Au moins une jauge de contrainte est fixée au deuxième élément de forme elliptique.

Le dispositif peut comporter plusieurs parties mobiles, chaque partie mobile étant reliée à la partie fixe par rapport au substrat par au moins un premier moyen de suspension. Au moins une jauge de contrainte est suspendue entre deux premiers moyens de suspension.

La présente invention a également pour objet un capteur comportant au moins un dispositif selon l'invention, et comportant des moyens de détection du déplacement de la partie mobile.

Les moyens de détection du déplacement de la partie mobile peuvent comporter au moins une jauge de contrainte, ladite jauge de contrainte étant une jauge piézorésistive. Avantageusement, il comporte deux jauges de contraintes reliées en différentiel et étant disposées de sorte que, lorsque l'une subit une compression, l'autre subit une traction.

Le capteur peut être un microphone, dans lequel la partie mobile est un diaphragme.

Le capteur peut être un accéléromètre, dans lequel la partie mobile est sensible aux forces résultant d'une accélération.

Le capteur peut être un gyromètre, comportant plusieurs parties suspendues par des éléments de suspension de forme courbe.

La présente invention a également pour objet un actionneur comportant au moins un dispositif selon invention, et comportant des moyens de déplacement de la partie suspendue.

## BRÈVE DESCRIPTION DES DESSINS

La présente invention sera mieux comprise sur la base de la description qui va suivre et des dessins en annexe sur lesquels:

- la figure 1A est une représentation schématique vue de dessus d'une suspension de l'état de la technique
- la figure 1B est une représentation schématique vue de dessus d'un exemple capteur dans le plan à détection piézorésistive de l'état de la technique mettant en œuvre une autre suspension que celle de la figure 1A,
- la figure 2A est une vue de dessus, représentée schématiquement, d'un exemple de dispositif MEMS et/ou NEMS selon l'invention,
- la figure 2A' est une vue de côté du dispositif de la figure 2A,
- la figure 2B est une vue du dispositif de la figure 2A avec les moyens de suspension à l'état déformé,
- la figure 2C est une vue de dessus, représentée schématiquement, d'une variante du dispositif MEMS et/ou NEMS de la figure 2A,

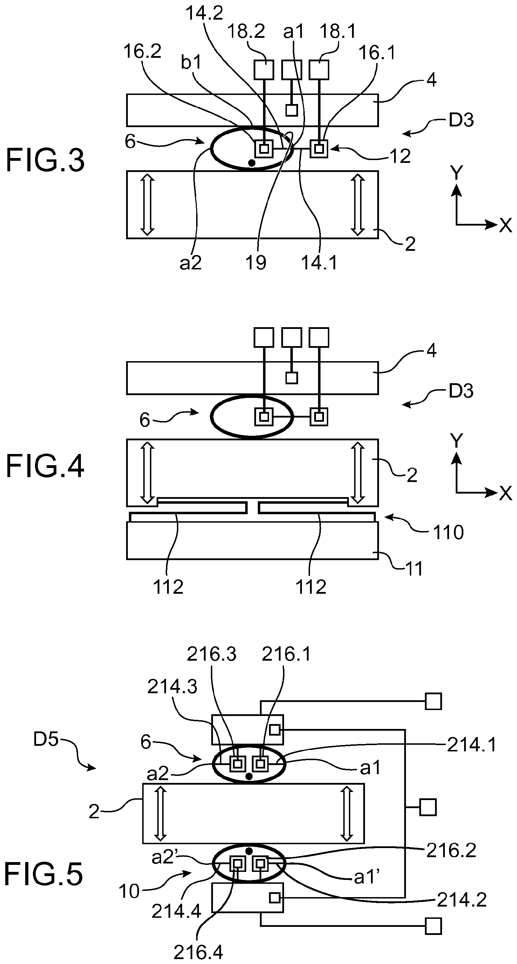

- la figure 3 est une vue de dessus, représentée schématiquement, d'un exemple de capteur selon l'invention,
- la figure 4 est une vue de dessus, représentée schématiquement, d'une variante du capteur de la figure 3,
- la figure 5 est une vue de dessus, représentée schématiquement, d'un autre exemple de capteur selon l'invention,

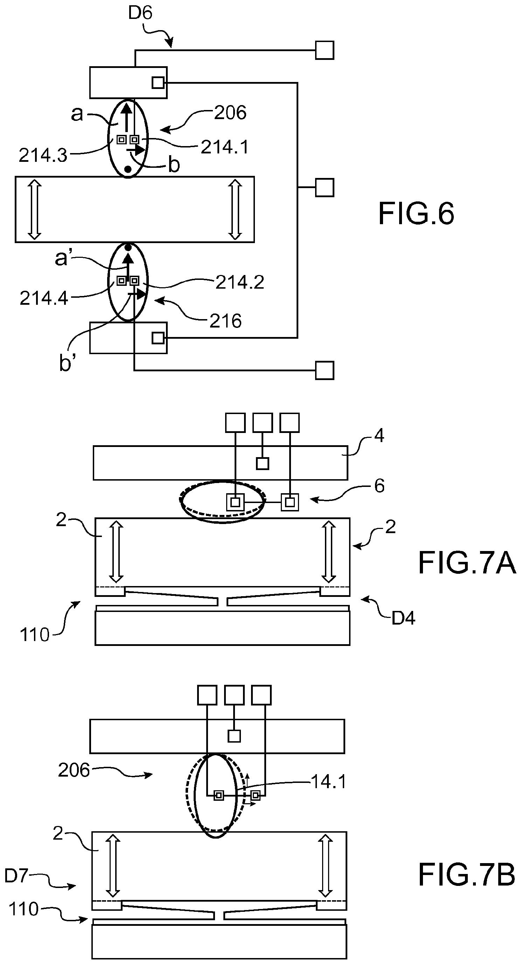

- la figure 6 est une vue de dessus, représentée schématiquement, d'une variante du capteur de la figure 5,
- les figures 7A et 7B sont des vues de dessus, représentées schématiquement, de capteurs selon l'invention, avec des exemples numériques de déplacement,

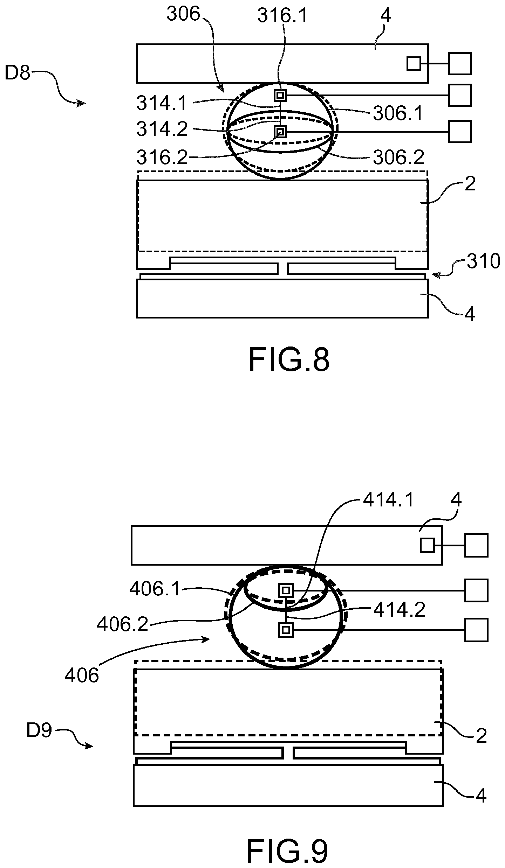

- la figure 8 est une vue de dessus, représentée schématiquement, d'un autre exemple de capteur selon l'invention,
- la figure 9 est une vue de dessus, représentée schématiquement, d'une variante du capteur de la figure 8,

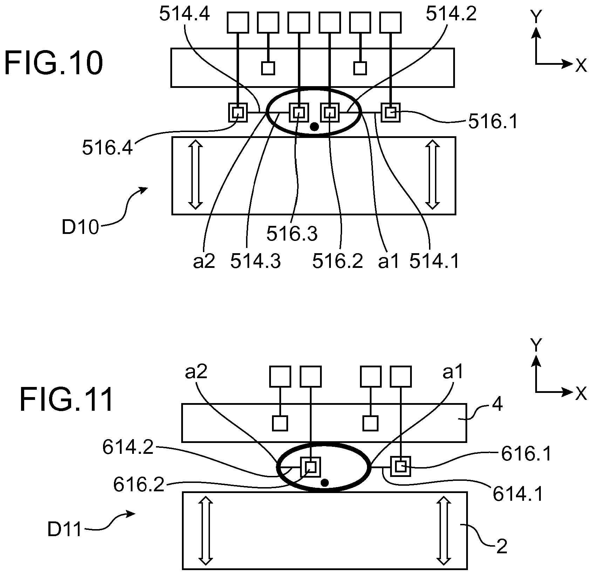

- la figure 10 est une vue de dessus, représentée schématiquement, d'un autre exemple de capteur selon l'invention,
- la figure 11 est une vue de dessus, représentée schématiquement, d'une variante du capteur de la figure 10,

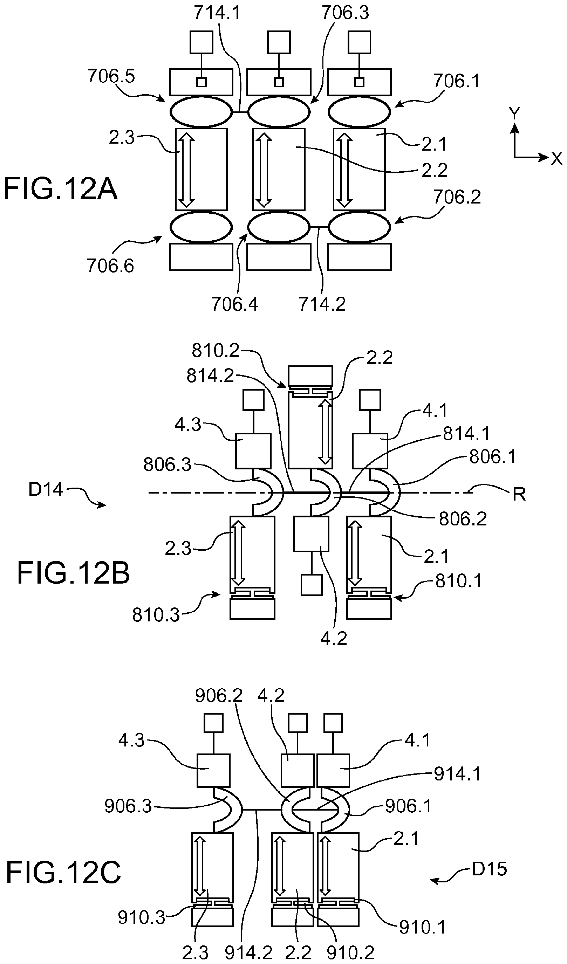

- les figures 12A à 12C sont des vues de dessus, représentées schématiquement, d'autres exemples de capteurs selon l'invention mettant en œuvre plusieurs masses,

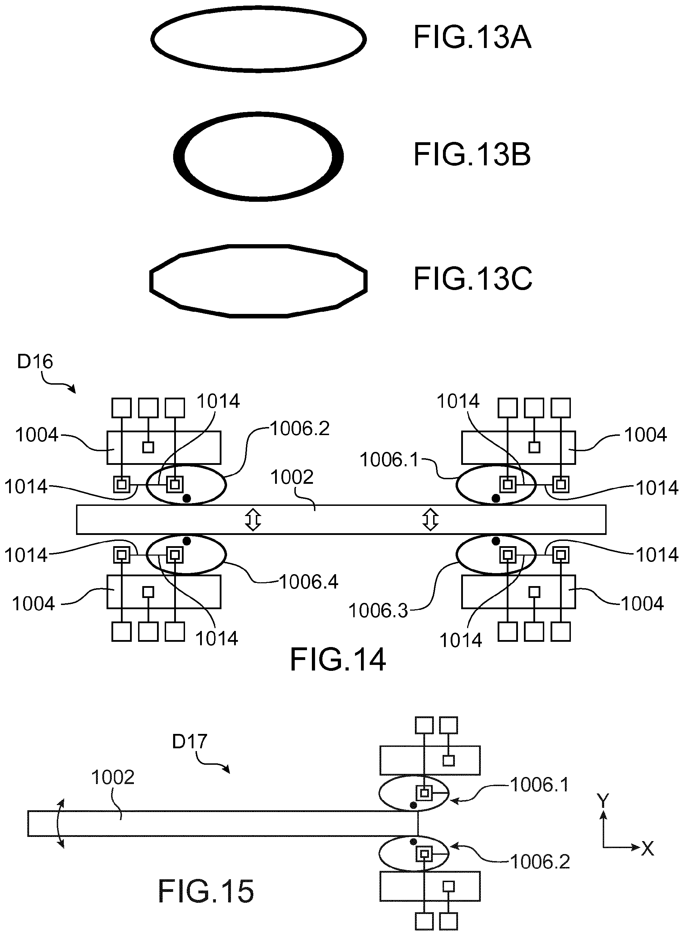

- les figures 13A à 13C sont des représentations schématiques de différents exemples de moyens de suspension selon l'invention,

- la figure 14 est une vue de côté, représentée schématiquement, d'un exemple de réalisation d'un microphone selon l'invention,
- la figure 15 est une vue de côté, représentée schématiquement, d'un autre exemple de réalisation de microphone selon l'invention,

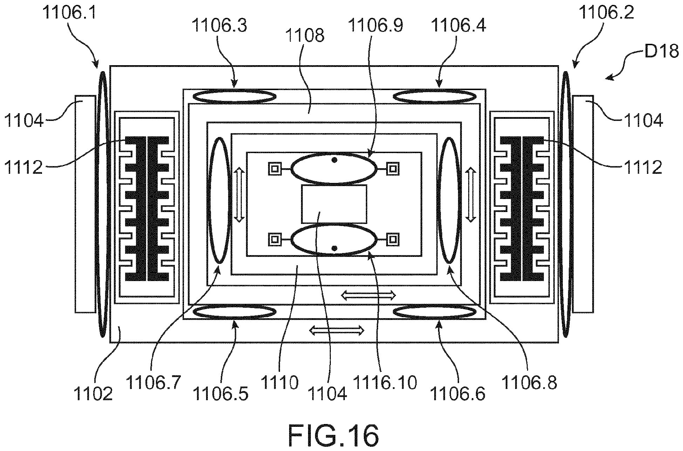

- la figure 16 est une vue de dessus, représentée schématiquement, d'un exemple de réalisation d'un gyromètre selon l'invention.

## EXPOSÉ DÉTAILLÉ DE MODES DE RÉALISATION PARTICULIERS

Dans la description qui va suivre, un dispositif MEMS et/ou NEMS sera désigné par dispositif MEMS à des fins de simplicité.

Le dispositif MEMS selon l'invention peut être un capteur ou un actionneur.

En outre, le dispositif MEMS comporte au moins une partie destinée à être déplacée par rapport au substrat, elle sera désignée « partie mobile », « élément mobile », « masse », « masse inertielle » ou « corps d'épreuve ».

Sur la figure 2A, on peut voir un exemple de dispositif MEMS D1 selon l'invention, vu de dessus, comportant une partie suspendue 2 à une partie fixe 4. La partie fixe est fixe mécaniquement par rapport au substrat mais peut être isolée électriquement ou non de celui-ci. La partie suspendue 2 peut être reliée électriquement ou non à la partie fixe 4. La partie suspendue 2 est destinée à être mobile par rapport à la partie fixe 4 dans le plan P du dispositif. La partie suspendue 2 peut être mise en mouvement par une force extérieure, telle une force résultant d'une accélération, soit être mise volontairement en mouvement par exemple par une force électrostatique, en appliquant une différence de potentiel électrique ou en injectant un courant électrique.

Sur la figure 2A', on peut voir une vue de côté du dispositif D1.

Le plan du dispositif est le plan s'étendant selon les axes X et Y dans la représentation de la figure 2A. La direction hors-plan est la direction orthogonale au plan P.

Le dispositif D1 comporte des premiers moyens de suspension 6 reliant mécaniquement la partie suspendue 2 à la partie fixe 4, tout en lui permettant de se déplacer dans le plan P.

Les premiers moyens de suspension 6 comportent deux éléments 8.1, 8.2 chacune de forme courbe.

Dans l'exemple représenté, les éléments 8.1 et 8.2 sont de forme semi-elliptique ou sensiblement semi-elliptique. Les éléments 8.1 et 8.2 sont disposés l'un par rapport à l'autre de sorte à former une ellipse ou sensiblement une ellipse.

L'élément 8.1 est relié à la partie suspendue 2 par une première extrémité 8.1' et à la partie fixe par une deuxième extrémité 8.1". L'élément 8.2 est relié à la partie suspendue 2 par une première extrémité 8.2' et à la partie fixe par une deuxième extrémité 8.2". Les extrémités 8.1' et 8.2' sont reliées l'une à l'autre et les extrémités 8.1" et 8.2" sont reliées l'une à l'autre.

Dans la présente demande, on entend par «élément courbe », un élément de forme incurvée dont la forme dans le plan P peut se décrire par un arc entre ses deux extrémités qui sont reliées d'une part à la partie mobile, et d'autre part à la partie fixe directement ou indirectement. L'élément de forme incurvée ne présente pas de zone anguleuse susceptible de concentrer les contraintes et devenir une zone de faiblesse.

La forme courbe ou incurvée peut être un arc d'ellipse, par exemple une semi-ellipse. La portion d'ellipse peut être issue d'une ellipse comportant un grand axe, un petit axe et deux foyers distincts ou d'un cercle et donc être un arc de cercle

Il sera compris que du fait des procédés de réalisation, les éléments de suspension n'ont pas forcément des formes parfaitement courbes.

Sur les figures 13A à 13C, on peut voir différents exemples de moyens de suspension selon l'invention. Sur la figure 13A, les moyens de suspension sont en forme d'ellipse et présentent une épaisseur sensiblement constante.

Sur la figure 13B, les moyens de suspension sont en forme d'ellipse et présentent une épaisseur variable, par exemple elle présente une plus grande épaisseur au niveau des extrémités du grand axe. Cette répartition d'épaisseur permet de répartir les contraintes, par exemple pour rigidifier certaines parties de la structure.

Sur la figure 13C, les moyens de suspension ont une forme générale d'ellipse, formés par une succession de segments, les segments étant de longueur très faible, l'élément ainsi formé est assimilable à une ellipse. Les déformations sont réparties sur les connexions entre les segments.

L'ellipse comporte un petit axe b et un grand axe a.

Lorsqu'une force de déplacement est appliquée à la partie suspendue 2 le long d'un axe Y parallèle à l'axe passant par le petit axe b, elle se déplace le long de l'axe Y et l'ellipse se déforme comme cela est représenté sur la figure 2B. La partie mobile 2 peut se déplacer en éloignement et en rapprochement de à la partie fixe 4 le long de l'axe Y.

Les éléments 8.1 et 8.2 sont déformés élastiquement.

Dans cet exemple de réalisation, la partie mobile 2 n'est suspendue que par les moyens de suspension 6.

Les moyens de suspension 6 ne comportent que des formes courbes et pas de zones anguleuses, ils ne présentent pas de zones susceptibles de concentrer les contraintes et d'être fragilisées. Les moyens de suspension sont donc plus robustes.

Dans le cas de l'ellipse, la contrainte est répartie plus uniformément, rendant les moyens de suspension plus robustes.

Dans l'exemple représenté, les moyens de suspension comportent deux éléments de forme courbe. Dans un autre exemple, les moyens de suspension comportent un seul élément de forme courbe tel que l'élément 8.1.

Sur la figure 2C, on peut voir un dispositif D2 selon une variante de réalisation du dispositif D1, comportant des deuxièmes moyens de suspension 10 situés à l'opposé des premiers moyens de suspension 6 par rapport à l'élément mobile 2, et suspendant également la partie mobile à la partie fixe 4. Le guidage de la partie mobile le long de la direction Y est amélioré.

Dans l'exemple représenté, les deuxièmes moyens de suspension 10 ont également une forme elliptique ou sensiblement elliptique. Dans cette variante, les ellipses des premiers et deuxièmes moyens de suspension sont de dimensions proches ou identiques. Selon une autre variante, les premiers et deuxièmes moyens de suspension sont de dimensions différentes. En variante encore, les deuxièmes moyens de suspension sont de type connu formés par des ressorts par exemple en forme de serpentin qui seront décrits ci-dessous. En variante encore, les moyens de suspension comportent un seul élément de forme courbe.

Lorsqu'une force est appliquée à l'élément mobile 2 le long de l'axe Y, les premiers moyens de suspension 6 sont déformés en élongation ou en compression le long de l'axe Y, et les deuxièmes moyens de suspension sont déformés en sens inverse, en compression ou en élongation le long de l'axe Y.

Les dispositifs D1 et D2 peuvent être mis en œuvre dans un capteur ou un actionneur.

Sur la figure 3, on peut voir un exemple de capteur MEMS et/ou NEMS D3 selon l'invention. Le capteur est par exemple un accéléromètre destiné à mesurer les accélérations. La partie suspendue est généralement désignée masse ou corps d'épreuve.

La structure du capteur D3 reprend la structure du dispositif D1 et comporte en outre des moyens de détection 12 du déplacement de la masse mobile 2

Dans cet exemple de réalisation, on souhaite détecter le déplacement de la masse 2 le long de la direction Y. Les moyens de détection sont donc tels qu'ils détectent le déplacement de la masse le long de la direction Y.

Dans cet exemple, les moyens de détection 12 comportent deux jauges de contrainte 14.1, 14.2, de préférence des jauges piézorésistives.

De préférence, les jauges sont alignées sur le grand axe a parallèle à la direction X orthogonale à la direction Y de déplacement.

Les extrémités du grand axe a sur l'ellipse sont désignées a1 et a2.

Chaque jauge 14.1, 14.2 est suspendue entre l'ellipse au point a1 et un plot d'ancrage 16.1, 16.2. Les plots d'ancrage 16.1, 16.2 sont disposés le long d'une droite (d) contenant le grand axe a, de part et d'autre du point a1.

Les plots d'ancrage forment également des plots de contact qui sont reliés à des contacts électriques 18.1, 18.2, permettant d'appliquer un potentiel aux jauges.

Le corps d'épreuve, la suspension et la partie fixe sont reliés à un contact électrique 19.

La disposition des jauges est telle que lorsque l'une est étirée, l'autre est comprimée. Cette disposition, associée à une alimentation et une mesure électriques adéquates via les connexions électriques, permet de réaliser une mesure différentielle des contraintes générées dans les deux jauges.

Comme cela est représenté sur la figure 3, lorsque la masse se déplace le long de l'axe Y en éloignement de la partie fixe 2, l'ellipse s'allonge le long du petit axe b, et les points a1 et a2 du grand axe se rapprochent du petit axe b, il en résulte une sollicitation en traction de la jauge 14.1 et une sollicitation en compression de la jauge 14.2.

En outre du fait de la forme en ellipse et de l'orientation de celle-ci par rapport à la direction de déplacement, il en résulte une réduction de l'amplitude du déplacement du point a1 par rapport au déplacement du point b1, qui est l'extrémité du petit axe du côté de la partie fixe 4. En effet les variations de longueur du grand axe et du petit axe sont liées. Soit lb la longueur du petit axe, dlb la variation de longueur du petit axe, la longueur du grand axe, dla la variation de longueur du grand axe, alors

$$dla = lb/la \; dlb.$$

Par conséquent, en fonction de l'orientation de l'ellipse et la disposition des jauges, il est possible soit d'amplifier l'amplitude du déplacement à détecter, soit de le réduire. Dans le cas d'un cercle, l'amplitude de la déformation transmise d'un axe à l'autre est la même.

Dans l'exemple de D3, puisque la masse est déplacée le long du petit axe et la jauge est sollicitée le long du grand axe, le rapport d'amplification est inférieur à 1, le déplacement de l'extrémité de la jauge lié à l'élément elliptique est inférieur à celle de la masse. Cette configuration permet par exemple de limiter la déformation de la jauge dans le cas de déplacements importants de la masse.

Le capteur D3 selon l'invention, dans lequel la masse se déplace en translation, offre une plus grande robustesse par rapport aux capteurs mettant en œuvre une masse mobile en rotation dans le plan. En effet, ce capteur ne met pas en œuvre de moyens de suspension présentant des zones où peuvent se concentrer les contraintes.

De plus, la forme elliptique permet d'avoir un rendement mécanique par rapport à l'énergie transmise à la jauge de contrainte, sensiblement supérieur à celui obtenu avec une forme comprenant des liaisons pivots, car la déformation élastique est répartie sur l'ensemble de la forme elliptique et non localisée dans les liaisons pivots. Par exemple, dans le cas d'une forme elliptique, le rendement est de l'ordre de 80%-90%, alors que pour une forme comprenant des liaisons pivots il est de l'ordre de 40%-50%.

En outre, le capteur D3 présente l'avantage d'être de conception plus simple qu'un capteur à masse articulée en rotation. En effet dans le cas des capteurs à masse articulée en rotation, les couplages entre les variables de dimensionnement sont nombreux et complexifient la conception des capteurs. Par exemple, l'effet de bras de levier qui intervient dans la structure des capteurs à masse articulée en rotation et assure un effet amplificateur sur la sensibilité est difficile à mettre en œuvre du fait des contraintes technologiques qui limitent les valeurs de la distance entre le pivot et la jauge de contrainte.

Dans le capteur selon l'invention, les couplages entre les variables de dimensionnement sont moins nombreux : le coefficient d'amplification dépend de la géométrie de l'ellipse. Le dimensionnement du capteur est alors facilité par cette séparation des variables.

Sur la figure 4, on peut voir un autre exemple de capteur D4 selon l'invention.

Le capteur D4 diffère du capteur D3, en ce qu'il comporte des deuxièmes moyens de suspension 110 situés à l'opposé des premiers moyens de suspension 6 par rapport à l'élément mobile 2, et suspendant également l'élément mobile à une autre partie 11 fixe par rapport au substrat.

Dans l'exemple représenté, les deuxièmes moyens de suspension comportent des ressorts 112 en forme de serpentin.

La mise en œuvre de ces deuxièmes moyens de suspension permet de contraindre le déplacement de la masse le long de la direction Y, limitant les déplacements parasites le long de la direction X et également les déplacements hors-plan dans la direction Z orthogonale aux directions X et Y.

Le capteur D4 est donc moins sensible aux accélérations selon les directions X et Z que le capteur D3.

Selon une variante, les deuxièmes moyens de suspension 110 en forme de serpentin sont remplacés par une ellipse.

Sur la figure 5, on peut voir un autre exemple de capteur D5 selon l'invention.

La masse mobile 2 du capteur D5 est suspendue par des premiers et deuxièmes moyens de suspension 6 et 10 de forme elliptique ou sensiblement elliptique fixés à la masse sur des côtés opposés de celle-ci.

Dans cet exemple, les moyens de détection du déplacement de la masse sont répartis dans les premiers et deuxièmes moyens de suspension.

Il comporte une première jauge 214.1 suspendue entre un plot d'ancrage 216.1 situé dans l'ellipse des premiers moyens de suspension et le point a1 de l'ellipse des premiers moyens de suspension. Il comporte également une deuxième jauge 214.2 suspendue entre un plot d'ancrage 216.2 situé dans l'ellipse des deuxièmes moyens de suspension et le point a1' de l'ellipse des deuxièmes moyens de suspension. Les plots d'ancrage 216.1, 216.2 sont reliés électriquement à des contacts électriques et sont montés en différentiel. De préférence, chaque première et deuxième jauge est alignée avec le grand axe de l'ellipse à laquelle elle est suspendue.

Dans l'exemple représenté et de manière avantageuse, le capteur comporte une troisième jauge 214.3 suspendue entre un plot d'ancrage 216.3 situé dans l'ellipse des premiers moyens de suspension et le point a2 de l'ellipse des premiers moyens de suspension, et une quatrième jauge 214.4 suspendue entre un plot d'ancrage 216.4 situé dans l'ellipse des deuxièmes moyens de suspension et le point a2' de l'ellipse des deuxièmes moyens de suspension.

La troisième jauge 214.3 est alignée avec la première jauge 214.1 et la quatrième jauge 214.4 est alignée avec la deuxième jauge 214.2. Dans l'exemple représenté, les troisième 214.3 et quatrième 214.4 jauges ne participent pas à la détection, mais leur présence assure une symétrie de la structure, ce qui permet d'équilibrer mécaniquement la structure lors du fonctionnement. Les plots d'ancrages 216.3 et 216.4 ne sont pas reliés électriquement à des contacts électriques.

En variante les moyens de détection mettent en œuvre les quatre jauges 214.1, 214.2, 214.3 et 214.4.

Selon une autre variante, le capteur ne comporte que les jauges 214.1 et 214.2.

Le fonctionnement du capteur D5 va maintenant être décrit.

Lorsqu'une accélération selon Y vers le bas dans la représentation de la figure 5 est appliquée au capteur, la masse se déplace vers le bas, l'ellipse des premiers moyens de suspension s'étire le long de l'axe Y tandis que l'ellipse des deuxièmes moyens de suspension est comprimée le long de l'axe Y.

La première jauge 214.1 est alors sollicitée en compression et la deuxième jauge 214.2 est sollicitée en traction. Une mesure différentielle est alors obtenue.

Ce capteur présente l'avantage d'être peu sensible aux accélérations selon les directions X et Z.

Sur la figure 6, on peut voir un autre exemple de capteur D6 selon l'invention.

La structure du capteur D6 diffère de celle du capteur D5, en ce que les ellipses des premiers moyens de suspension 206 et des deuxièmes moyens de suspension 210 sont disposées de sorte que ce soit leur grand axe a et a' qui soit aligné avec l'axe de déplacement Y et non plus leur petit axe b, b'.

La première jauge 214.1 est alignée avec le petit axe b et la deuxième jauge 214.2 est aligné avec le petit axe b'.

De manière avantageuse des troisième et quatrième jauges sont prévues pour équilibrer la structure.

Du fait de l'orientation des moyens de suspension, la variation de longueur qui s'applique à la jauge 214.1 s'écrit dlb/2 = ½ la/lb dla. De même pour la jauge 214.2, la variation de longueur s'écrit dlb'/2 = ½ la'/lb' dla', la' et lb' étant la longueur des axes a' et b' respectivement.

Or la étant supérieure à lb et la' étant supérieure à lb', les rapports la/lb et la'/lb' sont supérieurs à 1. Pour un rapport d'amplification supérieur à 2, il résulte donc une amplification du déplacement de la partie mobile transmis aux jauges 214.1, 214.2.

Sur les figures 7A et 7B, on peut voir le capteur D4 et un capteur D7 qui diffère du capteur D4 par l'orientation de l'ellipse des premiers moyens de suspension.

Des exemples de dimensionnement et de déplacement sont présentés à titre d'illustration.

Les deux structures présentent un rapport la/lb = 5.

Pour le capteur D4, il s'agit d'un rapport de réduction et pour le capteur D7 il s'agit d'un rapport d'amplification.

Pour le capteur D4, un déplacement du point b1 selon la direction Y de 2 $\mu$m provoque un déplacement du point a1 selon l'axe X de 0,2 $\mu$m. La longueur du petit axe varie de 2 $\mu$m et la longueur du grand axe varie de 0,4 $\mu$m.

Pour le capteur D7, un déplacement du point b1 selon la direction Y de 0,08 $\mu$m provoque un déplacement du point a1 selon l'axe X de 0,2 $\mu$m. La longueur du petit axe varie de 0,08 $\mu$m et la longueur du grand axe varie de 0,4 $\mu$m.

Pour un même déplacement du point a1, le déplacement selon Y est beaucoup plus faible pour le capteur D7, et plus généralement pour un capteur dont l'ellipse est orientée de sorte que son grand axe soit parallèle à la direction de déplacement.

Il en résulte une sollicitation transverse de l'extrémité de la jauge 14.1 qui est fixée à l'élément de suspension elliptique réduite.

Sur la figure 8, on peut voir un autre exemple de capteur D8 selon l'invention présentant une sollicitation transverse des jauges nulle.

Le capteur D8 comporte une masse mobile 2, une partie fixe 4 par rapport au substrat, des premiers moyens de suspension 306 entre une première partie fixe 4 et la masse 2 et des deuxièmes moyens de suspension 310 entre la masse et une deuxième partie fixe par rapport au substrat, les premiers et deuxièmes moyens de suspension étant fixés à des bords opposés de la masse.

Les deuxièmes moyens de suspension 310 sont par exemple des ressorts de suspension.

Les premiers moyens de suspension comportent un premier élément de forme elliptique 306.1 et un deuxième élément de forme elliptique 306.2.

Le premier élément de forme elliptique 306.1 est fixé à la partie fixe 4 et à la masse au niveau des extrémités de son petit axe b, et assure la suspension de la masse à la partie fixe 4 par rapport au substrat.

Le deuxième élément de forme elliptique 306.2 est disposé dans le premier élément de forme elliptique 306.1 et est fixé à celui-ci de sorte qu'une déformation du premier élément 306.1 provoque une déformation du deuxième élément 306.2.

Dans l'exemple représenté, le premier élément 306.1 a au repos sensiblement la forme d'un cercle.

Les extrémités du grand axe du deuxième élément 306.2 sont fixées aux extrémités du grand axe du premier élément 306.1.

En outre, des jauges 314.1, 314.2 sont suspendues entre une extrémité du petit axe du deuxième élément 306.2 et des plots d'ancrage 316.1, 316.2. Elles sont également disposées de sorte que, lorsque l'une est sollicitée en traction, l'autre est sollicitée en compression. En outre les jauges sont alignées avec la direction de déplacement de la masse à mesurer.

Les jauges sont connectées à des contacts électriques et sont connectées en différentiel.

Ainsi, lorsque la masse se déplace le long de la direction Y (vers le haut dans la représentation de la figure 8), le premier élément 306.1 se contracte le long de la direction Y et s'allonge le long de la direction X, ce qui pour effet d'allonger le deuxième élément le long de la direction X et de contracter le deuxième élément le long de la direction Y sollicitant l'une des jauges en traction et l'autre jauge en compression. Les éléments 306.1, 306.2 représentés en pointillés sont les éléments 306.1, 306.2 dans un état déformé.

Cet exemple présente l'avantage de réduire, voire supprimer, les sollicitations transverses de la ou des jauges. En effet, grâce à cette structure de moyens de suspension, les jauges sont soumises à une contrainte le long de leur axe longitudinal. Il en résulte une contrainte quasi-homogène, voire homogène dans tout le volume des jauges ainsi qu'au niveau de leurs points d'ancrage. La robustesse est alors accrue. Il en résulte une variation de résistivité homogène dans les jauges. Le courant se répartit donc de manière homogène dans les jauges et la linéarité de la réponse piézorésistive est améliorée.

En outre, cette structure de moyens de suspension permet de découpler les variables, ce qui permet de dimensionner indépendamment les jauges et la masse.

Sur la figure 9, on peut voir un dispositif D9 selon une variante du dispositif D8.

Les moyens de suspension du capteur D9 comportent des moyens de suspension 406 comprenant un premier élément de forme elliptique 406.1 et un deuxième élément de forme elliptique 406.2 disposé dans le premier élément 406.1. Une extrémité du petit axe du deuxième élément 406.2 est au moins fixée à une extrémité du petit axe du premier élément 406.1. Dans l'exemple représenté, les contours des premier et deuxième éléments 406.1, 406.2 sont confondus en partie. Mais une solidarisation au niveau des extrémités des petits axes uniquement ne sort pas du cadre de la présente invention.

Comme pour le capteur D8, les jauges 414.1, 414.2 sont suspendues entre une extrémité du petit axe du deuxième élément 406.2 et des plots d'ancrage 416.1, 416.2. Elles sont également disposées de sorte que, lorsque l'une est sollicitée en traction, l'autre est sollicitée en compression.

En outre les jauges sont alignées avec la direction de déplacement de la masse à détecter.

Le fonctionnement est similaire à celui du capteur D8, les jauges sont sollicitées essentiellement le long de leur axe longitudinal offrant un capteur plus robuste et une réponse plus linéaire.

Sur la figure 10, on peut voir un autre exemple de capteur D10 selon l'invention.

Le capteur D10 comporte une structure proche du capteur D1. Il diffère de celui-ci en ce que quatre jauges 514.1, 514.2, 514.3, 514.4 sont mises en œuvre.

Une paire de jauges 514.1, 514.2 est suspendue entre une extrémité a1 du grand axe de l'élément de forme elliptique et de plots d'ancrage 516.1, 516.2. Une paire de jauges 514.3, 514.4 est suspendue entre une extrémité a2 du grand axe de l'élément de forme elliptique et de plots d'ancrage 516.3, 516.4.

Les deux paires de jauges sont disposées symétriquement par rapport au petit axe. La structure est alors équilibrée mécaniquement.

Dans l'exemple représenté, toutes les jauges sont reliées électriquement à des contacts électriques et peuvent servir à la détection. Le capteur peut utiliser les signaux générés par les deux paires de jauges ou uniquement les signaux générés par l'une des paires de jauges. En variante, seules les jauges de l'une des paires sont reliées électriquement à des contacts électriques et sont utilisées pour la mesure.

Sur la figure 11, on peut voir un autre exemple de capteur D11 présentant une structure équilibrée.

Dans cet exemple, le capteur D11 comporte une jauge 614.1 suspendue entre l'extrémité a1 du grand axe de l'élément de forme elliptique et un plot d'ancrage 616.1 situé à l'extérieur de l'élément de forme elliptique, et une jauge 614.2 suspendue entre l'autre extrémité a2 du grand axe de l'élément de forme elliptique et un plot d'ancrage 616.2 situé à l'intérieur de l'élément de forme elliptique. Les deux jauges sont connectées électriquement en différentiel.

Lorsque la masse se déplace le long de l'axe Y, la déformation de l'élément de forme elliptique applique une traction sur l'une des jauges et une compression sur l'autre jauge.

On peut envisager, pour les capteurs D10 et D11, qu'une seule des deux jauges serve à la mesure, l'autre jauge étant mise en œuvre pour équilibrer mécaniquement la structure.

Sur les figures 12A à 12C, on peut voir d'autres exemples de capteurs selon l'invention mettant en œuvre plusieurs masses.

Sur la figure 12A, le capteur D13 comporte trois masses 2.1, 2.2, 2.3.

La masse 2.1 est suspendue à la partie fixe par deux moyens de suspension 706.1, 706.2 comportant chacun un élément de forme elliptique.

La masse 2.2 est suspendue à la partie fixe par deux moyens de suspension 706.3, 706.4 comportant chacun un élément de forme elliptique.

La masse 2.3 est suspendue à la partie fixe par deux moyens de suspension 706.5, 706.6 comportant chacun un élément de forme elliptique.

Le capteur comporte également des moyens de mesure du déplacement des masses mobiles. Les masses sont identiques et lorsqu'elles sont soumises à une force extérieure elles subissent le même déplacement.

Les moyens de mesure comportent une première jauge suspendue 714.1 entre le moyen de suspension 706.5 et le moyen de suspension 706.3, la jauge 714.1 étant alignée avec les grands axes des moyens de suspension 706.5, 706.3.

Les moyens de mesure comportent une deuxième jauge 714.2 suspendue entre le moyen de suspension 706.4 et le moyen de suspension 706.2, la jauge 714.2 étant alignée avec les grands axes des moyens de suspension 706.4, 706.2.

Lorsque les masses 2.1, 2.2, 2.3 se déplacent le long de l'axe Y vers le bas dans la représentation de la figure 12A, la jauge 714.1 est étirée, alors que la jauge 714.2 est comprimée, permettant une mesure différentielle.

Dans cet exemple les jauges 714.1, 714.2 ne subissent pas ou peu de sollicitation transverse puisque les deux extrémités des jauges sont déplacées simultanément et dans le même sens le long de la direction Y.

Sur la figure 12B, on peut voir un autre exemple de capteur D14 comportant également trois masses 2.1, 2.2, 2.3.

Dans cet exemple, chaque masse est suspendue à une partie fixe par rapport au substrat 4.1, 4.2, 4.3 par un moyen de suspension 806.1, 806.2, 806.3 selon l'invention et par un moyen de suspension 810.1, 810.2, 810.3 de l'état de la technique. Il sera compris que tous les moyens de suspension pourraient être selon l'invention, ou une partie seulement. Les parties fixes 4.1, 4.2, 4 .3 sont immobiles les unes par rapport aux autres et généralement d'un seul tenant.

Dans cet exemple, les moyens de suspension 806.1, 806.2, 806.3 comportent un élément en forme de demi-ellipse. Les trois demi-ellipses ont la même orientation et leurs grands axes sont alignés.

En considérant le plan R passant par les grands axes des demi-ellipses et s'étendant selon la direction hors-plan, la masse 2.2 située entre les deux masses 2.1 et 2.3 est située de l'autre côté du plan R par rapport aux masses 2.1 et 2.3, et la partie fixe 4.2 à laquelle est reliée la masse 2.2 est située de l'autre côté du plan R par rapport aux parties fixes 4.1 et 4.3. Ainsi, lorsque les masses se déplacent le long de l'axe Y dans un sens donné, les masses 2.1, 2.3 s'éloignent ou se rapprochent des parties fixes 4.1, 4.3 alors que la masse 2.2 se rapproche ou s'éloigne de la partie fixe 4.2 respectivement.

Le dispositif comporte des moyens de détection comportant une jauge 814.1 suspendue entre les moyens de suspension 806.1 et 806.2 et la jauge 814.2 suspendue entre les moyens de suspension 806.2 et 806.3. En outre les jauges sont alignées avec les grands axes des demi-ellipses.

Par exemple, lorsque les masses subissent un déplacement vers le bas dans la représentation de la figure 12B, la jauge 814.1 est soumise à une force de compression et la jauge 814.2 est soumise à une force de traction.

Dans cet exemple, les jauges 814.1, 814.2 ne subissent également pas ou peu de sollicitation transverse, puisque les deux extrémités des jauges sont déplacées simultanément et dans le même sens le long de la direction Y.

Sur la figure 12C, on peut voir un autre exemple de capteur D15 comportant également trois masses 2.1, 2.2, 2.3.

Les masses ont la même disposition que pour le dispositif D13.

Dans cet exemple, chaque masse est suspendue aux parties fixes par rapport au substrat 4.1, 4.2, 4.3 par un moyen de suspension 906.1, 906.2, 906.3 selon l'invention et par un moyen de suspension 910.1, 910.2, 910.3 de l'état de la technique. Il sera compris que tous les moyens de suspension pourraient être selon l'invention, ou une partie seulement.

Dans cet exemple, les moyens de suspension 906.1, 906.2, 906.3 comportent un élément en forme de demi-ellipse.

Les demi-ellipses 906.1 et 906.2 sont symétriques l'une de l'autre de sorte à dessiner une ellipse.

La demi-ellipse 906.3 a la même orientation que la demi-ellipse 906.1.

Le dispositif comporte des moyens de détection comportant une jauge 914.1 suspendue entre les moyens de suspension 906.1 et 906.2 et une jauge 914.2 suspendue entre les moyens de suspension 906.2 et 906.3. En outre les jauges sont alignées avec les grands axes des demi-ellipses.

Par exemple, lorsque les masses subissent un déplacement vers le bas dans la représentation de la figure 12C, la jauge 914.1 est soumise à une force de compression et la jauge 914.2 est soumise à une force de traction.

Dans cet exemple, les jauges 914.1, 914.2 ne subissent également pas ou peu de sollicitation transverse puisque les deux extrémités des jauges sont sollicitées simultanément et dans le même sens le long de la direction Y.

Les capteurs selon l'invention peuvent être utilisés comme capteur de pression, accéléromètre, gyromètre, magnétomètre...

Sur la figure 14, on peut voir un exemple de microphone D16 mettant en œuvre des moyens de suspension selon l'invention.

Le microphone D16 comporte un diaphragme 1002 suspendu à une partie fixe 1004 par quatre moyens de suspension 1006.1, 1006.2, 1006.3, 1006.4.

Les quatre moyens de suspension ont une forme d'ellipse.

En outre il comporte des moyens de détection du déplacement du diaphragme. Les moyens de détection comportent des jauges de contraintes 1014 tels que ceux mis en œuvre dans le dispositif D3.

Dans cet exemple, des moyens de détection sont prévus au niveau de chaque moyen de suspension, mais il pourrait être prévu un seul moyen de détection sur chaque bord du diaphragme.

Sur la figure 15, on peut voir un autre exemple de microphone D17 mettant en œuvre des moyens de suspension selon l'invention. Le microphone D17 diffère du microphone D16 en ce que le diaphragme est encastré à une seule de ses extrémités, par deux moyens de suspension 1006.1, 1006.2 de part et d'autre de l'extrémité du diaphragme. La description des moyens de suspension et des moyens de détection du microphone D16 s'appliquent. Le diaphragme se déplace en rotation autour de son extrémité encastrée et l'amplitude du signal résultante est potentiellement plus grande par rapport au microphone D16.

Selon un autre exemple de réalisation, les moyens de suspension suspendent une ou des parties mobiles à au moins une autre partie mobile. Sur la figure 16, on peut voir un exemple de gyromètre D18 mettant en œuvre des moyens de suspension selon l'invention entre parties mobiles.

Le gyromètre D18 met en œuvre des moyens de suspension entre les différents éléments le composant. Le gyromètre comporte une partie suspendue 1102 destiné à l'excitation du gyromètre, elle est suspendue à deux parties fixes 1104 par deux moyens de suspension 1106.1, 1106.2 selon l'invention, orientés de sorte à favoriser le déplacement selon la direction X.

Le gyromètre comporte une partie mobile 1108 sensible aux forces de Coriolis, suspendue à la partie d'excitation 1102 à l'intérieur de celle-ci, par quatre moyens de suspension 1106.3, 1106.4, 1106.5, 1106.6, orientés de sorte à favoriser le déplacement du cadre 1108 selon la direction Y tout en l'assujettissant aux déplacements en X de la partie d'excitation 1002.

Le gyromètre comporte une partie de détection 1110 suspendue entre la partie sensible 1108 par deux moyens de suspension 1106.7, 1106.8, et à la partie fixe 1104 par deux moyens de suspension 1106.9, 1106.10. Les moyens de suspension 1106.7, 1106.8 sont orientés de sorte à favoriser l'isolation mécanique selon la direction X de partie de détection par rapport aux autres parties et la transmission du signal selon la direction Y de la partie suspendue vers la partie détection. Les moyens de suspension 1106.9, 1106.10 sont orientés de sorte que leur petit axe soit parallèle à la direction Y.

Le gyromètre comporte des moyens de détection piézorésistifs similaires à ceux mis en œuvre dans le capteur D5, mais la partie fixe 1104 est disposée au centre et les jauges sont à l'extérieur des ellipses. En variante, la disposition des moyens de détection dans le capteur D5 peut s'appliquer.

Le gyromètre comporte des moyens pour mettre en mouvement la partie d'excitation. Dans l'exemple représenté il s'agit de peignes électrostatiques à variation de surface 1112. En variante, des moyens d'excitation à moyens d'entrefer sont mis en œuvre.

Le déplacement des différents éléments est symbolisé par les flèches.

Un gyromètre dans lequel une partie des moyens de suspension est selon l'invention et une autre partie comporte des moyens de suspension de l'état de la technique ne sort pas du cadre de la présente invention.

Le principe de détection décrit ci-dessus pour les capteurs pourrait être transposé pour réaliser des actionneurs mettant en mouvement la masse mobile en remplaçant les jauges piézorésistives par des matériaux piézoélectriques. En mettant en œuvre des moyens de suspension elliptiques ou semi-elliptiques, on peut bénéficier avantageusement de l'amplification du mouvement imposée par les moyens de suspension, ou éventuellement de la réduction du mouvement.

En outre on peut également réaliser des actionneurs électrostatiques, thermiques... mettant en œuvre les moyens de suspension selon l'invention.

De plus, les moyens de détection pourraient être par exemple des moyens de détection capacitifs.

De plus un dispositif comportant des moyens de détection ne forme pas nécessairement un capteur, il peut s'agir d'un actionneur, les moyens de détection, par exemple les jauges, étant utilisés pour connaître le déplacement de la partie mobile et surveiller la position de la partie mobile. D'autres moyens peuvent être utilisés pour actionner la partie mobile.

En outre, les modes et exemple de réalisation peuvent être combinés, notamment les moyens de suspension mis en œuvre dans un exemple peuvent être mis en œuvre dans un autre exemple décrit.

De manière préférée, les moyens de détection sont tels qu'ils permettent une mesure différentielle. Il sera compris que des moyens de détection ne permettant pas de mesure différentielle peuvent être mis en œuvre dans les dispositifs selon l'invention. Par exemple, une seule jauge pourrait être utilisée dans le dispositif D3. Ou alors deux jauges peuvent être utilisées mais une seule réalisant la mesure.

Dans les exemples décrits, les moyens de suspension selon l'invention relient directement la partie mobile à une partie fixe par rapport au substrat.

Selon un autre exemple de réalisation, le dispositif peut comporter plusieurs éléments de suspension selon l'invention entre une partie fixe par rapport au substrat et la même partie mobile, par exemple les éléments de suspension étant soit chacun lié à la partie fixe et à la masse, soit liés entre eux, ou entre deux parties mobiles. Les éléments de suspension peuvent être identiques ou différents.

Le dispositif selon l'invention est réalisé par des techniques de la microélectronique mettant en œuvre par exemple des étapes de lithographie, gravure, libération.

Des masques de lithographie adaptés à la forme des éléments de suspension sont utilisés.

## Revendications

1. Dispositif microélectromécanique et/ou nanoélectromécanique comportant une partie fixe (4) par rapport à un substrat, au moins une partie suspendue (2) par rapport à ladite partie fixe (4) destinée à être mobile dans le plan dudit dispositif par rapport à la partie fixe (4) le long au moins d'une première direction (Y), et un premier moyen de suspension (6) de ladite partie suspendue (2), ledit premier moyen de suspension (6) comportant au moins un élément de suspension (8.1, 8.2), ledit élément de suspension (8.1, 8.2) comportant une première extrémité (8.1") fixée directement à la partie suspendue (2) et une deuxième extrémité (8.1') reliée à la partie fixe (4), ledit élément de suspension (8.1, 8.2) présentant une forme courbe dans le plan et s'étendant entre la première extrémité (8.1') et la deuxième extrémité (8.1") et telle que lors du déplacement dans le plan de ladite partie suspendue (2), ledit élément de suspension (8.1, 8.2) soit uniquement déformé élastiquement, dans lequel ledit au moins un élément de suspension (8.1, 8.2) est en forme au moins de demi-ellipse, **caractérisé en ce que** le dispositif comporte également au moins une jauge de contrainte (14.1, 14.2), dont une des extrémités de ladite au moins une jauge est fixée sur l'élément de suspension (8.1, 8.2) et l'autre est ancrée sur la partie fixe par rapport au substrat.

2. Dispositif selon la revendication 1, dans lequel le premier moyen de suspension comporte deux éléments de suspension (8.1, 8.2), chacun en forme de demi-ellipse, et disposés l'un par rapport à l'autre de sorte à former une ellipse.

3. Dispositif selon la revendication 1 ou 2, comportant un deuxième moyen de suspension (10) comportant au moins un élément de suspension de ladite partie suspendue (2) à ladite partie fixe (4), ledit élément de suspension comportant une première extrémité fixée directement à la partie suspendue (2), et une deuxième extrémité reliée à la partie fixe, ledit élément de suspension ayant une projection dans le plan présentant une forme courbe contenue dans le plan, et s'étendant entre la première extrémité et la deuxième extrémité et telle que, lors du déplacement dans le plan de ladite partie suspendue, ledit élément de suspension soit uniquement déformé élastiquement, ledit deuxième moyen de suspension étant disposé par rapport à la partie mobile et aux premiers moyens de suspension, de sorte que, lors d'un déplacement de la partie mobile, lorsque le premier moyen de suspension (6) est déformé en compression, le deuxième moyen de suspension (10) est déformé en traction et inversement.

4. Dispositif selon l'une des revendications 1 à 3, comportant au moins deux jauges de contrainte (14.1, 14.2) chacune étant fixée à un élément de suspension.

5. Dispositif selon la revendication 3, dans lequel le premier moyen de suspension et le deuxième moyen de suspension comportent chacun deux éléments de suspension, chaque élément de suspension étant en forme de demi-ellipse, et disposés l'un par rapport à l'autre de sorte à former une ellipse et dans lequel le premier moyen de suspension et/ou le deuxième moyen de suspension est (sont) orienté(s) de sorte que leur grand axe (a) est parallèle à la première direction, et au moins une jauge de contrainte est alignée avec le petit axe, de sorte que l'extrémité mobile de la jauge de contrainte subisse un déplacement amplifié par rapport à celui de la partie mobile.

6. Dispositif selon la revendication 3 ou 5, dans lequel le premier moyen de suspension (6) et/ou le deuxième moyen de suspension (10) comporte(nt) un premier élément de forme elliptique et un deuxième élément de forme elliptique disposé dans le premier élément de forme elliptique et lié mécaniquement à celui-ci, le premier élément de forme elliptique étant fixé sur la partie mobile et le deuxième élément de forme elliptique étant fixé uniquement sur le premier élément de forme elliptique et dans lequel au moins une jauge de contrainte est fixée au deuxième élément de forme elliptique.

7. Dispositif selon l'une des revendications 1 à 6, comportant plusieurs parties mobiles, chaque partie mobile étant reliée à la partie fixe par rapport au substrat par au moins un premier moyen de suspension, et dans lequel au moins une jauge de contrainte est suspendue entre deux premiers moyens de suspension.

8. Capteur comportant au moins un dispositif selon l'une des revendications 1 à 7, et comportant des moyens de détection du déplacement de la partie mobile.

9.  Capteur selon la revendication 8, dans lequel les moyens de détection du déplacement de la partie mobile comportent au moins une jauge de contrainte, ladite jauge de contrainte étant une jauge piézorésistive.

10. Capteur selon la revendication 9, comportant deux jauges de contraintes reliées en différentiel et étant disposées de sorte que, lorsque l'une subit une compression, l'autre subit une traction.

11. Capteur selon la revendication 8, 9 ou 10, formant un microphone, dans lequel la partie mobile est un diaphragme.

12. Capteur selon la revendication 8, 9 ou 10 formant un accéléromètre, dans lequel la partie mobile est sensible aux forces résultant d'une accélération.

13. Capteur selon la revendication 8, 9 ou 10 formant un gyromètre, comportant plusieurs parties suspendues par des éléments de suspension de forme courbe.

14. Actionneur comportant au moins un dispositif selon l'une des revendications 1 à 7, et comportant des moyens de déplacement de la partie suspendue.

**Patentansprüche**

1.  Mikroelektromechanische und/oder nanoelektromechanische Vorrichtung mit einem bezüglich eines Substrats feststehenden Teil (4), zumindest einem bezüglich des feststehenden Teils (4) aufgehängten Teil (2), das dazu bestimmt ist, in der Ebene der Vorrichtung bezüglich des feststehenden Teils (4) entlang zumindest einer ersten Richtung (Y) beweglich zu sein, einem ersten Aufhängungsmittel (6) für das aufgehängte Teil (2), wobei das erste Aufhängungsmittel (6) zumindest ein Aufhängungselement (8.1, 8.2) enthält, wobei das Aufhängungselement (8.1, 8.2) ein erstes Ende (8.1"), das direkt an dem aufgehängten Teil (2) befestigt ist, und ein zweites Ende (8.1'), das mit dem feststehenden Teil (4) verbunden ist, aufweist, wobei das Aufhängungselement (8. 1, 8.2) eine in der Ebene gekrümmte Form hat und sich zwischen dem ersten Ende (8.1') und dem zweiten Ende (8.1") erstreckt, derart, dass bei einer Verschiebung des aufgehängten Teils (2) in der Ebene das Aufhängungselement (8.1, 8.2) nur elastisch verformt wird, wobei das zumindest eine Aufhängungselement (8.1, 8.2) eine zumindest halb-elliptische Form aufweist, **dadurch gekennzeichnet, dass** die Vorrichtung ferner zumindest einen Dehnungsmessstreifen (14.1, 14.2) aufweist, wobei eines der Enden des zumindest einen Dehnungsmessstreifens an dem Aufhängungselement (8.1, 8.2) befestigt ist und das andere Ende an dem bezüglich des Substrats feststehenden Teil verankert ist.

2.  Vorrichtung nach Anspruch 1, wobei das erste Aufhängungsmittel zwei Aufhängungselemente (8.1, 8.2) enthält, die jeweils eine halbelliptische Form haben und so zueinander angeordnet sind, dass sie eine Ellipse bilden.

3.  Vorrichtung nach Anspruch 1 oder 2, enthaltend ein zweites Aufhängungsmittel (10), das zumindest ein Aufhängungselement zum Aufhängen des aufgehängten Teils (2) an dem feststehenden Teil (4) enthält, wobei das Aufhängungselement ein erstes Ende, das direkt an dem aufgehängten Teil (2) befestigt ist, und ein zweites Ende, das mit dem feststehenden Teil verbunden ist, aufweist, wobei das Aufhängungselement eine Projektion in der Ebene hat, die eine in der Ebene enthaltene gekrümmte Form aufweist, und sich zwischen dem ersten Ende und dem zweiten Ende erstreckt, derart, dass bei der Verschiebung des aufgehängten Teils in der Ebene das Aufhängungselement nur elastisch verformt wird, wobei das zweite Aufhängungsmittel in Bezug auf das bewegliche Teil und auf die ersten Aufhängungsmittel so angeordnet ist, dass bei einer Verschiebung des beweglichen Teils, wenn das erste Aufhängungsmittel (6) auf Druck verformt wird, das zweite Aufhängungsmittel (10) auf Zug verformt wird und umgekehrt.

4.  Vorrichtung nach einem der Ansprüche 1 bis 3, enthaltend zumindest zwei Dehnungsmessstreifen (14.1, 14.2), die jeweils an einem Aufhängungselement befestigt sind.

5.  Vorrichtung nach Anspruch 3, wobei das erste Aufhängungsmittel und das zweite Aufhängungsmittel jeweils zwei Aufhängungselemente enthalten, wobei die Aufhängungselemente jeweils eine halbelliptische Form haben und so zueinander angeordnet sind, dass sie eine Ellipse bilden, und wobei das erste Aufhängungsmittel und/oder das zweite Aufhängungsmittel so ausgerichtet ist/sind, dass ihre Hauptachse (a) parallel zu der ersten Richtung verläuft, und zumindest ein Dehnungsmessstreifen mit der Nebenachse ausgerichtet ist, so dass das bewegliche Ende des Dehnungsmessstreifens eine bezüglich des beweglichen Teils verstärkte Verschiebung erfährt.

6.  Vorrichtung nach Anspruch 3 oder 5, wobei das erste Aufhängungsmittel (6) und/oder das zweite Aufhängungsmittel (10) ein erstes Element mit elliptischer Form und ein zweites Element mit elliptischer Form enthält/enthalten, das in dem ersten Element mit elliptischer Form angeordnet und mit diesem mechanisch verbunden ist, wobei das erste Element mit elliptischer Form an dem beweglichen Teil befestigt ist und das zweite Element mit elliptischer Form nur an dem ersten Element mit elliptischer Form befestigt ist und wobei zumindest ein Dehnungsmessstreifen an dem zweiten Element mit elliptischer Form befestigt ist.

7. Vorrichtung nach einem der Ansprüche 1 bis 6, enthaltend mehrere bewegliche Teile, wobei jedes bewegliche Teil mit dem bezüglich des Substrats feststehenden Teil durch zumindest ein erstes Aufhängungsmittel verbunden ist, und wobei zumindest ein Dehnungsmessstreifen zwischen zwei ersten Aufhängungsmitteln aufgehängt ist.

8. Sensor mit zumindest einer Vorrichtung nach einem der Ansprüche 1 bis 7 und mit Mitteln zur Erfassung der Verschiebung des beweglichen Teils.

9. Sensor nach Anspruch 8, wobei die Mittel zur Erfassung der Verschiebung des beweglichen Teils zumindest einen Dehnungsmessstreifen enthalten, wobei der Dehnungsmessstreifen ein piezoresistiver Messstreifen ist.

10. Sensor nach Anspruch 9, enthaltend zwei Dehnungsmessstreifen, die differenziell angeschlossen und so angeordnet sind, dass dann, wenn einer eine Druckkraft erfährt, der andere eine Zugkraft erfährt.

11. Sensor nach Anspruch 8, 9 oder 10, wobei er ein Mikrofon bildet, bei dem das bewegliche Teil eine Membran ist.

12. Sensor nach Anspruch 8, 9 oder 10, wobei er einen Beschleunigungsmesser bildet, bei dem der bewegliche Teil auf aus einer Beschleunigung resultierende Kräfte empfindlich ist.

13. Sensor nach Anspruch 8, 9 oder 10, wobei er ein Gyrometer bildet, enthaltend mehrere Teile, die mittels Aufhängungselementen gekrümmter Form aufgehängt sind.

14. Stellantrieb mit zumindest einer Vorrichtung nach einem der Ansprüche 1 bis 7 und mit Mitteln zum Verschieben des aufgehängten Teils.

**Claims**

1. Microelectromechanical and/or nanoelectromechanical device comprising a fixed part (4) with respect to a substrate, at least one suspended part (2), with respect to the fixed part (4), configured to be moveable in the plane of said device with respect to the fixed part along at least one first direction (Y), and a first suspension means (6) for suspending said suspended part (2), said first suspension means (6) comprising at least one suspension element (8.1, 8.2), said suspension element (8.1, 8.2) comprising a first end (8.1") fixed directly to the suspended part (2) and a second end (8.1') connected to the fixed part (4), said suspension element (8.1, 8.2) having a curved shape contained in the plane and extending between the first end (8.1') and the second end (8.1") and such that during the displacement in the plane of said suspended part (2), said suspension element (8.1, 8.2) is only deformed elastically, in which said at least one suspension element (8.1, 8.2) is at least of half-ellipse shape, **characterized in that** the device comprises at least one strain gauge (14.1, 14.2), of which one of the ends of said at least one strain gauge is fixed on the suspension element (8.1, 8.2) and the other is anchored on the fixed part with respect to the substrate.

2. Device according to claim 1, in which the first suspension means comprise two suspension elements (8.1, 8.2), each of half-ellipse shape, and arranged with respect to each other so as to form an ellipse.

3. Device according to claim 1 or 2, comprising a second suspension means (10) comprising at least one element for suspending said suspended part (2) from said fixed part (4), said suspension element comprising a first end fixed directly to the suspended part (2), and a second end connected to the fixed part, said suspension element having a curved shape contained in the plane, and extending between the first end and the second end and such that, during the displacement in the plane of said suspended part, said suspension element is only deformed elastically, said second suspension means being arranged with respect to the moveable part and to the first suspension means, such that, during a displacement of the moveable part, when the first suspension means is deformed in compression, the second suspension means is deformed in traction and vice versa.

4. Device according to one of the claims 1 to 3, comprising at least two strain gauges (14.1, 14.2) each being fixed to a suspension element.

5. Device according to claim 3, in which the first suspension means and of the second suspension means comprise two suspension elements, each of half-ellipse shape, and arranged with respect to each other so as to form an ellipse and in which the first suspension means and/or the second suspension means is (are) oriented such that their major axis (a) is parallel to the first direction, and at least one strain gauge is aligned with the minor axis, such that the moveable end of the strain gauge undergoes a displacement amplified with respect to that of the moveable part.

6. Device according to one of the claims 3 to 5, in which the first suspension means (6) and/or the second suspension means (10) comprise a first elliptically shaped element and a second elliptically shaped element arranged in the first elliptically shaped element and mechanically connected thereto, the first elliptically shaped element being fixed on the moveable part and the second elliptically shaped element being fixed only on the first elliptically shaped element and in which at least one strain gauge is fixed to the second elliptically shaped element.

7. Device according to one of the claims 1 to 6, comprising several moveable parts, each moveable part being connected to the fixed part with respect to the substrate by at least one first suspension means, and in which at least one strain gauge is suspended between two first suspension means.

8. Sensor comprising at least one device according to one of the claims 1 to 7, and comprising a detector for detecting the displacement of the moveable part.

9. Sensor according to claim 8, in which the detector comprises at least one strain gauge, said strain gauge being a piezoresistive gauge.

10. Sensor according to claim 9, comprising two strain gauges differentially connected and being arranged such that, when one undergoes a compression, the other undergoes a traction.

11. Sensor according to claim 8, 9 or 10, forming a microphone, in which the moveable part is a diaphragm.

12. Sensor according to claim 8, 9 or 10, forming an accelerometer, in which the moveable part is sensitive to the forces resulting from an acceleration.

13. Sensor according to claim 8, 9 or 10, forming a gyrometer, comprising several parts suspended by suspension elements of curved shape.

14. Actuator comprising at least one device according to one of the claims 1 to 7, and comprising a device for displacing the suspended part.

FIG.1A

FIG.1B

FIG.2A

FIG.2A'

FIG.2B

FIG.2C

FIG.3

FIG.4

FIG.5

FIG.6

FIG.7A

FIG.7B

306    316.1    4

D8

314.1    306.1
314.2
316.2    306.2

2

310

4

## FIG.8

414.1    4

406.1
406.2    414.2

406

D9

2

4

## FIG.9

FIG.10

514.4           514.2

Y
X

516.4

516.1

D10

a2 514.3    516.3    516.2    a1 514.1

FIG.11

a2           a1

Y
X

4

614.2

616.2

616.1

614.1

D11

2

FIG.12A

FIG.12B

FIG.12C

EP 3 498 661 B1

FIG.13A

FIG.13B

FIG.13C

FIG.14

FIG.15

21

FIG.16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2491406 A
- WO 2007136096 A
- US 20160349056 A